# EUROPEAN PATENT APPLICATION

(11) **EP 1 170 776 A2**
(43) Date of publication of application: **09.01.2002**
(21) Application number: 01116357.3
(22) Date of filing: 05.07.2001
(51) Int. Cl.: H01J 37/32, C23C 14/32

(54) **Vacuum arc evaporation source and film formation apparatus using the same**

(30) Priority: 06.07.2000 JP 2000204961
(71) Applicant: Nissin Electric Co., Ltd., Kyoto-shi, Kyoto 615 (JP)
(72) Inventor: Murakami, Hiroshi, Ukyo-ku, Kyoto-shi, Kyoto 615 (JP)
(74) Representative: Grünecker, Kinkeldey, Stockmair & Schwanhäusser Anwaltssozietät

(57) **Abstract**

A vacuum arc evaporation source 30 evaporates cathodes by vacuum arc discharge to thereby generate plasmas 36 and 38 containing cathode materials. The vacuum arc evaporation source 30 has two cathodes 32 and 34 composed of different kinds of materials from each other and insulated electrically from each other. The cathodes 32 and 34 are disposed coaxially with each other through an insulating material 40. The two cathodes 32 and 34 are used switchably, so that a laminate film including a plurality of heterogeneous films can be formed by evaporation sources which are smaller in number than those in the related art.

## Description

### BACKGROUND OF THE INVENTION

### 1. Field of the invention

The present invention relates to a vacuum arc evaporation source and a film formation apparatus using the same, for use in forming a thin film including a cathode material or a chemical compound containing the cathode material on a surface of a substrate of, for example, an automotive part, a machine part, a tool, a mold, an exterior part, or the like, so as to improve the substrate in wear resistance, sliding property, anti-seizing property, decoration property, and so on. More specifically, the present invention relates to a vacuum arc evaporation source and a film formation apparatus using the same for use in forming a laminate film including a plurality of heterogeneous films on a surface of a substrate.

### 2. Description of the related art

There is a method for forming a thin film on a surface of a substrate by drawing ions (which mean positive ions in this specification) in a plasma generated by a vacuum arc evaporation source toward the substrate by a negative bias voltage or the like. The vacuum arc evaporation source evaporates a cathode by vacuum arc discharge to thereby generate the plasma containing a cathode material. The above-mentioned method is also called an arc ion plating method. The arc ion plating method has such features that the film formation speed is high, the adhesion property of the film is high, or the like.

The reason why the film formation speed is high is that a large amount of the cathode material can be evaporated from the cathode by use of the vacuum arc discharge. The reason why the film adhesion property is high is that the ions in the plasma can be drawn toward the substrate and collided therewith by an electric field generated by the negative bias voltage or the like.

To improve the performance of the film, a laminate film including a plurality of heterogeneous films (different kinds of films from one another) may be formed on the surface of the substrate.

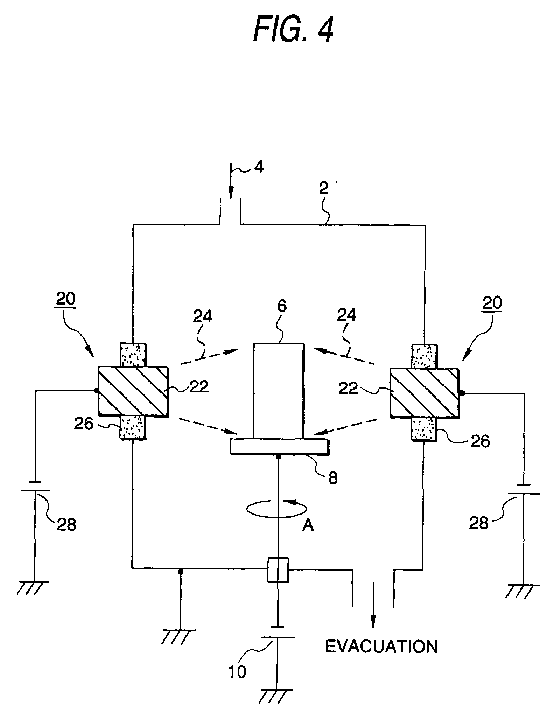

Fig. 4 shows a film formation apparatus for use in forming such a laminate film by the arc ion plating method in the related art. Such a film formation apparatus based on the arc ion plating method is also called an arc ion plating apparatus.

A holder 8 is provided in a vacuum vessel 2 which is vacuum-pumped by a not-shown vacuum pump system, and holds a substrate 6 on which films are formed. The substrate 6 may have a desired shape. The holder 8 and the substrate 6 are rotated, for embodiment in the direction shown by the arrow A in accordance with necessity.

In this example, a negative bias voltage, for example, in a range of from about minus tens of V to about minus 500 V is applied from a bias power supply 10 to the holder 8 and the substrate 6 held thereby. The vacuum vessel 2 is grounded.

Gas 4 is introduced into the vacuum vessel 2 in accordance with necessity. For example, the Gas 4 includes inert gas, or reactive gas, which reacts on cathode materials evaporated from cathodes 22 of the vacuum arc evaporation sources 20.

A plurality of (for example, two) vacuum arc evaporation sources 20 are attached to a wall surface of the vacuum vessel 2 at different places from each other, so as to be directed to the substrate 6 on the holder 8.

The respective vacuum arc evaporation sources 20 are to evaporate the cathodes 22 by the vacuum arc discharge so as to generate plasma 24 containing the cathode materials (Cathode materials mean materials including the cathodes) . Each of the vacuum arc evaporation sources 20 has one cathode 22, an insulating material 26 for insulating the cathode 22 and the vacuum vessel 2 from each other, and so on. The cathodes 22 of the respective vacuum arc evaporation sources 20 consist of different kinds of materials from each other. Each of the vacuum arc evaporation sources 20 is further provided with a lot of not-shown constituent parts, that is, a trigger electrode, a magnet, a water-cooling system, a vacuum seal mechanism, etc.

In this example, the vacuum vessel 2 also serves as an anode for the respective vacuum arc evaporation sources 20. For example, an arc discharge voltage in a range of from about tens of V to about 100 V is applied between the vacuum vessel 2 as an anode and the respective cathodes 22 from respective arc power supplies 28. However, an anode electrode may be provided separately.

When the arc discharge voltage is applied between the cathode 22 and the vacuum vessel 2, the vacuum arc discharge is producedbetween them, so that the cathode 22 are heated locally and cathode material evaporates from the heated cathode 22. At this time, in vicinity of the surface of the cathode 22 directed to the substrate 6, plasma is generated by the arc discharge so that the cathode materials are ionized partially. That is, plasma 24 containing the ionized cathode materials is generated in vicinity of the surface of the cathode 22 directed to the substrate 6.

The ionized cathode materials in the plasma 24 are attracted to the substrate 6 by the bias voltage and deposited thereon. Thus, a thin film including the cathode materials is formed on the surface of the substrate 6. At that time, if reactive gas (for example, nitrogen gas) is introduced into the vacuum vessel 2 as the gas 4, the reactive gas reacts on the cathode materials so that a chemical compound (for example, nitride) thin film is formed on the surface of the substrate 6.

By such means, in the related art, one vacuum arc evaporation source 20 is used for forming one kind of thin film. That is, the vacuum arc evaporation sources 20 are installed in the vacuum vessel 2 so that the number of the vacuum arc evaporation sources 20 corresponds to the number of kinds of films composing a laminate film formed on the surface of the substrate 6, and then the respective vacuum arc evaporation sources 20 are operated sequentially so as to form the laminate film on the surface of the substrate 6.

For example, in order to form a chrome nitride (CrN) thin film on a titanium nitride (TiN) thin film formed on the surface of the substrate 6, two vacuum arc evaporation sources 20 are installed in the vacuum vessel 2. The material of one of the cathodes 22 is made of titanium while the material of the other cathode 22 is made of chrome. Then, the respective vacuum arc evaporation sources 20 are operated sequentially in a nitrogen atmosphere so that a laminate film having one or more layers of titanium nitride and one or more layers of chrome nitride are formed on the surface of the substrate 6.

In the related art as described above, it is necessary to install the vacuum arc evaporation sources 20 in the vacuum vessel 2 so that the number of the vacuum arc evaporation sources 20 corresponds to the number of kinds of films composing the laminate film. Therefore, if the number of kinds of films composing the laminate film increases, the number of the vacuum arc evaporation sources 20 increases, and hence the vacuum vessel 2 becomes large in size inevitably. As a result, the film formation apparatus as a whole becomes large in size. Thus, the vacuum pump system for the vacuum vessel 2 cannot help increasing in capacity. In accordance with the increase in size and capacity, the manufacturing cost of the film formation apparatus also increases.

In addition, though a plurality of vacuum arc evaporation sources 20 are installed in the vacuum vessel 2, when a laminate film is formed, one of the vacuum arc evaporation sources 20 is used while the other vacuum arc evaporation sources 20 are paused. Thus, the operation rate of the vacuum arc evaporation sources 20 deteriorates. That is, in order to form a laminate film including m kinds of different films (m is an integer not smaller than 2), the operation rate of the vacuum arc evaporation sources 20 is 1/m. Therefore, the film formation speed is low and the film formation productivity is low in comparison with the number of the installed vacuum arc evaporation sources 20.

In addition, the cathode materials evaporated from the cathodes 22 of the vacuum arc evaporation sources 20 usually contain coarse particles (also called macro-particles or droplets) undesirably for film formation. Adhesion of such coarse particles to the substrate 6 gives an adverse effect to film characteristics, for example, deterioration in the adhesion of films. To prevent such a problem, a magnetic filter may be provided to generate a magnetic field for curving the plasma 24 generatedby the vacuum arc evaporation sources 20, to thereby remove coarse particles in plasma 24. However, when a plurality of vacuum arc evaporation sources 20 is installed to form a laminate film, in the related art, it is necessary to provide magnetic filters for the respective vacuum arc evaporation sources 20. Thus, the structure of the film formation apparatus is complicated, the apparatus as a whole becomes large in size, and the apparatus cost also becomes high on a large scale.

### SUMMARY OF THE INVENTION

It is therefore an object of the present invention to provide a vacuum arc evaporation source which can form a laminate film including a plurality of heterogeneous films with evaporation source which is smaller in number than those in the related art.

The above-mentioned object can be achieved by a vacuum arc evaporation source, according to the present invention, comprising a plurality of cathodes composed of different kinds of materials from one another and insulated electrically from one another.

According to this vacuum arc evaporation source, the plurality of cathodes can be used switchably. Thus, a laminate film including a plurality of heterogeneous films can be formed by evaporation sources which are smaller in number than those in the related art. That is, if the number of cathodes in one. evaporation source is n (n is an integer not smaller than 2), the number of evaporation sources may be reduced to l/n of that intherelatedart. In addition, by using the cathodes switchably, one vacuum arc evaporation source can be used continuously, substantially without any pause. Thus, the operation rate of the one vacuum arc evaporation source is improved on a large scale. Thus, according to this vacuum arc evaporation source, the laminate film including the plurality of heterogeneous films can be formed at low cost and with improved productivity. In addition, a film formation apparatus for forming a laminate film including a plurality of heterogeneous films on a surface of a substrate can be made smaller in size and lower in cost, and improved in productivity.

The above-mentioned object can be also achieved by a film formation apparatus for forming a laminate film including a plurality of heterogeneous films on a surface of a substrate, according to the invention, comprising: a vacuum arc evaporation source including a plurality of cathodes; an arc power supply for supplying arc discharge power to the cathodes of the vacuum arc evaporation source; and a changeover switch for changing over the arc discharge power from the arc power supply among the plurality of cathodes of the vacuum arc evaporation source alternatively.

According to this film formation apparatus, the plurality of cathodes of the vacuum arc evaporation source can be used switchably. Thus, a laminate film including a plurality of heterogeneous films can be formed on the surface of the substrate at low cost and with improved productivity. In addition, the apparatus can be made smaller in size and lower in cost, and improved in productivity.

In addition, as the arc power supply and the changeover switch are provided as described above, one arc power supply is needed to be installed for one vacuum arc evaporation source including the plurality of cathodes. Thus, the number of arc power supplies can be reduced. Also from this point of view, the apparatus can be made simpler in configuration, smaller in size and lower in cost.

### BRIEF DESCRIPTION OF THE DRAWINGS

FIG. 1 is a sectional view partially showing a first embodiment of a film formation apparatus using a vacuum arc evaporation source according to the present invention;
FIG. 2 is a front view of a cathode portion of the vacuum arc evaporation source in Fig. 1;
FIG. 3 is a schematic view showing a second embodiment of a film formation apparatus using a vacuum arc evaporation source according to the present invention; and
FIG. 4 is a schematic view showing a film formation apparatus using a vacuum arc evaporation source in the related art.

### DETAILED DESCRIPTION OF THE PREFERED EMBODIMENTS

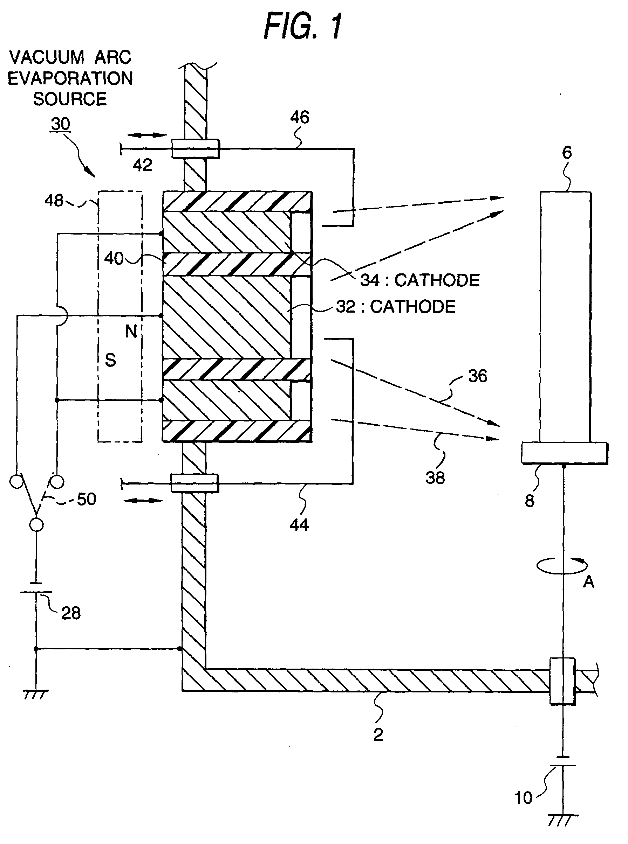

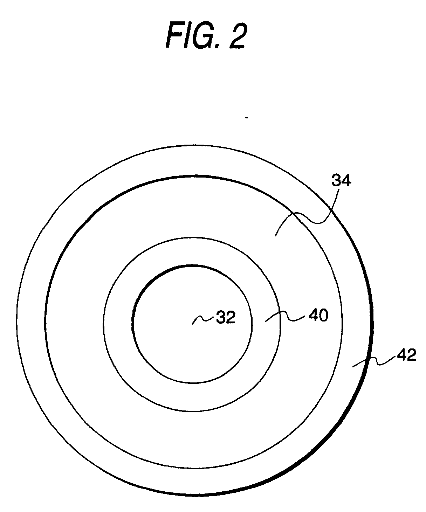

Fig. 1 is a sectional view partially showing a first embodiment of a film formation apparatus using a vacuum arc evaporation source according to the present invention. Fig. 2 is a front view of a cathode portion of the vacuum arc evaporation source in Fig. 1. Parts the same as or equivalent to those in the example shown in Fig. 4 are referenced correspondingly. Different points from the example will be explained mainly in the following description.

The film formation apparatus has a vacuum arc evaporation source 30, which is attached to the vacuum vessel 2 so as to be directed to a substrate 6 on a holder 8 inside the vacuum vessel 2. The number of vacuum arc evaporation sources 30 installed thus may be one or more in accordance with necessity.

In this embodiment, the vacuum arc evaporation source 30 has two cathodes 32 and 34 which are composed of different kinds of materials from each other and which are insulated electrically from each other. More specifically, in this embodiment, a columnar cathode 32 in the center portion of the vacuum arc evaporation source 30 and a cylindrical (which may be expressed as "annular") cathode 34 outside the cathode 32 are disposed coaxially with each other through a cylindrical insulating material 40 which electrically insulates the cathodes 32 and 34 from each other. In this embodiment, the outside electrode 34 and the vacuum vessel 2 are electrically insulated from each other by a cylindrical insulating material 42.

The combination of the materials of the cathodes 32 and 34 is optional, and the cathodes 32 and 34 can be selected suitably in accordance with kinds of films to be formed. For example, one of the cathodes 32 and 34 is titanium and the other is chromium. To improve the adhesion of a hard carbon thin film or the like, materials which will be described later may be selected.

A trigger electrode for arc ignition (start) may be provided movably between the cathodes 32 and 34 so as to serve in common for the cathodes 32 and 34. In this embodiment, however, a trigger electrode 44 for the cathode 32 and a trigger electrode 46 for the cathode 34 areprovided separately to make the structure simple.

Arc power supplies for supplying arc discharge power to the cathodes 32 and 34 of this vacuum arc evaporation source 30 may be provided one to one for the cathodes 32 and 34 respectively. In this embodiment, however, for one vacuum arc evaporation source 30, there are provided one arc power supply 28 for supplying arc discharge power to the cathode 32 or 34 , and a changeover switch 50 for changing over the arc discharge power from the arc power supply 28 between the two cathodes 32 and 34 alternatively.

The two cathodes 32 and 34 of this vacuum arc evaporation source 30 are electrically insulated from each other by the insulating material 40. Therefore, if arc discharge power is supplied to one of the cathodes 32 and 34, arc discharge is produced only in the one cathode. That is, by switching the changeover switch 50 to the cathode 32 side, vacuum arc discharge can be produced between the cathode 32 and the vacuum vessel 2. Thus, the cathode 32 is heated and evaporated locally so that plasma 36 containing the cathode material of the cathode 32 can be generated. As a result, by the same operation as that described in detail in the related art, a thin film including the cathode material contained in the plasma 36 or a thin film including a chemical compound obtained from the cathode material and the reactive gas can be formed on the substrate 6.

On the contrary, by switching the changeover switch 50 to the cathode 34 side, the vacuum arc discharge can be produced between the cathode 34 and the vacuum vessel 2. As a result, the cathode 34 is heated and evaporated locally so that plasma 38 containing the cathode material of the cathode 34 can be generated. Thus, a thin film including the cathode material contained in the plasma 38 or a thin film including the chemical compound obtained from the cathode material and the reactive gas can be formed on the substrate 6.

In such a case, a cathode point (arc spot) of the arc discharge is moved about at random on the surface of the cathode 32 or 34 by the electromagnetic force generated by the arc itself. The whole surface of the cathode 32 or 34 can evenly be used to generate plasma 36 containing the cathode materials of the cathode 32 or 34 without depending on the plane shape of the cathode 32 or 34. Even the cathode 34 of the cylindrical shape can evenly be used to generate plasma 36 containing the cathode materials of the cathode 34 without depending on the plane shape of the cathode 34. Therefore, the cathodes 32 and 34 can be used substantially evenly. For example, a magnet (e.g. permanent magnet) 48 as shown by the two-dot chain line in Fig. 1, or a magnet having another magnetic pole arrangement may be provided near the back surfaces of the cathodes 32 and 34. In such a case, the motion of the cathode point of the arc discharge can be controlled by the magnetic field of the magnet 48 or the like. Thus, both the cathodes 32 and 34 can be used to generate plasma 36 containing the cathode materials of the cathode 32 or 34.

In addition, in this embodiment, the cathodes 32 and 34 of the vacuum arc evaporation source 30 are disposed coaxially with each other. Accordingly, the positions of the plasmas 36 and 38 generated by use of the cathodes 32 and 34 have substantially the same position relative to each other, and there is no fear that the positions of the plasmas 36 and 38 are shifted largely from each other. It is therefore possible to form films on the same substrate 6 substantially on the same conditions, more conveniently for forming a laminate film.

As mentioned the above, The two cathodes 32 and 34 of the vacuum arc evaporation source 30 are changed over suitably in use. More specifically, the cathodes 32 and 34 are changed over after one of the cathodes 32 and 34 has formed a film with a predetermined film thickness. Thus, a laminate film including a plurality of heterogeneous films can be formed on the surface of the substrate 6. For example, if such changing-over is performed once, a laminate film having one layer for each of the heterogeneous films can be formed. If such change-over is performed a plurality of times, a laminate filmhaving aplurality of layers for each of the heterogeneous films can be formed.

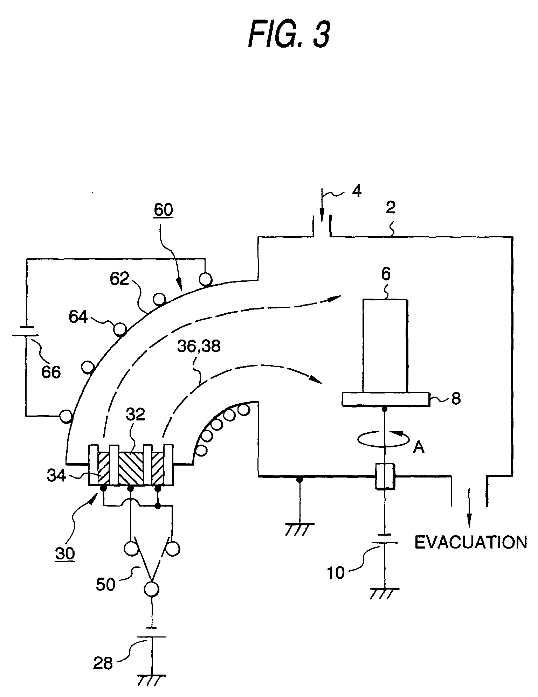

Incidentally, in the same conception as that in the above-mentioned embodiment, for example, three or more cathodes which are composed of different kinds of materials from one another and which are electrically insulated from one another may be provided in the vacuum arc evaporation source 30. The same thing may be applied to the case of the embodiment of Fig. 3.

According to this vacuum arc evaporation source 30, the plurality of cathodes 32 and 34 can be used switchably. Thus, a laminate film including a plurality of heterogeneous films can be formed on the substrate 6 by evaporation sources which are smaller in number than those in the related art. That is, if the number of cathodes is n (n is an integer not smaller than 2) in one vacuum arc evaporation source, the number of evaporation sources may be reduced to l/n of that in the related art. In addition, by using the cathodes 32 and 34 switchably, one vacuum arc evaporation source 30 can be used continuously, substantially without any pause. Thus, the operation rate of the one vacuum arc evaporation source 30 is also improved on a large scale.

Thus, according to the vacuum arc evaporation source 30, a laminate film including a plurality of heterogeneous films can be formed at low cost and with improved productivity. In addition, the film formation apparatus for forming a laminate film including a plurality of heterogeneous films on the surface of the substrate 6 can be made smaller in size and lower in cost, and improved in productivity.

According to the film formation apparatus having such a vacuum arc evaporation source 30, the plurality of cathodes 32 and 34 of the vacuum arc evaporation source 30 can be used switchably. Thus, for the same reason as described above, a laminate film including a plurality of heterogeneous films can be formed on the surface of the substrate 6 at low cost and with improved productivity. In addition, the apparatus can be made smaller in size and lower in cost, and improved in productivity.

In addition, the arc power supply 28 and the changeover switch 50 are provided as described above in the film formation apparatus. Therefore, merely one arc power supply 28 is required for one vacuum arc evaporation source 30 having the plurality of cathodes. Thus, the number of arc power supplies can be reduced. Also from this point of view, the apparatus can be made simpler in configuration, smaller in size and lower in cost.

Incidentally, the plane shapes of the plurality of above-mentioned cathodes 32 and 34 of the vacuum arc evaporation source 30 may be quadrangles or the like other than circles. However, it is preferable that they aremade circular as described in the above-mentioned embodiment. If they are made circular, it becomes easy to manufacture the respective cathodes 32 and 34.

However, when a hard carbon thin film such as a diamond-like carbon film, a diamond film, or the like, is formed on the surface of a metal substrate 6, the following laminate structure may be adopted to improve the adhesion of the hard carbon thin film. That is, an intermediate thin film containing metal of a group 4A (e.g. Ti), 5A (e.g. Ta) or 6A (e.g. Cr) in the periodic table (for example, consisting of such metal or carbide thereof) is formed between the hard carbon thin film and the substrate 6. This is because such metal of the group 4A, 5A or 6A or the carbide thereof is well fit for the metal substrate 6 and has not only the high adhesion thereto, but also well fit for the carbon thin film and has the high adhesion thereto. Thus, from the point of view of the laminate film as a whole, the adhesion of the hard carbon thin film is improved.

The vacuum arc evaporation source 30 canbe used for forming such a laminate film. In such a case, as the plurality of cathodes, (1) a cathode including a material containing carbon (e.g. graphite), and (2) a cathode including a material containing metal of the above-mentioned group 4A, 5A or 6A (for example, the cathode consists of such metal or carbide thereof) may be used. For example, when the number of cathodes is two as shown in the embodiment of Fig. 1, the cathode (1) may be adopted as one of the cathodes (for example, cathode 32) while the cathode (2) may be adopted as the other cathode (for example, cathode 34).

By use of the vacuum arc evaporation source 30 having such a cathode arrangement, a high-adhesion hard carbon thin film can be formed on the surface of the metal substrate 6 at low cost and with improved productivity. The reason why such a thin film can be formed at low cost and with improved productivity is that the number of evaporation sources can be reduced and the operation rate thereof is high, as described above in detail.

Fig. 3 is a schematic view showing a second embodiment of a film formation apparatus using a vacuum arc evaporation source according to the present invention. Here, the vacuum arc evaporation source 30 is shown simply.

A different point from the embodiment of Fig. 1 will be described mainly. In this embodiment, a magnetic filter 60 is provided between the vacuum arc evaporation source 30 and a vacuum vessel 2 which are arranged as described above. The magnetic filter 60 generates a magnetic field for curving plasmas 36 and 38 generated by the vacuum arc evaporation source 30 in order to thereby remove coarse particles from plasmas 36 and 38 and to introduce the plasmas 36 and 38 which are removed the coarse particles into the vicinity of a substrate 6.

In this embodiment, the magnetic filter 60 has a curved transport duct 62, a magnetic coil 64 for forming a magnetic field curved along this transport duct 62, and a DC power supply 66 for exciting this magnetic coil 64. The magnetic coil 64 may be a solenoid coil wound around the transport duct 62 as in the illustratedembodiment, or may be of a plurality of toroidal coils. Alternatively, in place of the magnetic coil 64, a plurality of permanent magnets may be used to form a curved magnetic field as described above. In such a case, the DC power supply 66 is not necessary.

The plasmas 36 and 38 generated by the vacuum arc evaporation source 30 are transported in the magnetic filter 60 along the magnetic field thereof, and introduced into the vicinity of the substrate 6 in the vacuum vessel 2. At that time, of coarse particles included in the plasmas 36 and 38, those which have no charges are not affected by the magnetic field and hence not transported to the substrate 6. Even in the case of each coarse particle having a charge, as the radius (Lamar radius) of its screwmotion in the magnetic field increases extremely in proportion to its mass, such coarse particles collide with the inner wall of the transport duct 62, a fin (not shown) provided to project on the inner wall of the transport duct 62, or the like, and thus the coarse particles disappear (adhere) . As a result, the plasmas 36 and 38 which rarely include coarse particles are transported into the vacuum vessel 2, and introduced into the vicinity of the substrate 6. It is therefore possible to prevent the coarse particles from adhering to the substrate 6. Thus, a laminate film which is high in adhesion and surface smoothness can be formed on the substrate 6.

According to the above-mentioned vacuum arc evaporation source 30, a laminate film can be formed by evaporation sources which are smaller in number than those in the related art, as described above. In accordance therewith, the number of magnetic filters 60 can be reduced. Accordingly, when such a magnetic filter 60 is provided, the film formation apparatus can be made simpler in structure, smaller in size and lower in cost, correspondingly.

Incidentally, in accordance with necessity, two or more sets of vacuum arc evaporation sources 30, changeover switches 50, arc power supplies 28 and magnetic filters 60 may be provided for one vacuum vessel 2.

Each of the above-mentioned embodiments showed the case where a negative bias voltage was applied from the bias power supply 10 to the substrate 6. However, even if the substrate 6 is not applied with a negative bias voltage but set into the ground potential without any bias power supply 10, the plasmas 36 and 38 transported to the vicinity of the substrate 6 are apt to have a positive potential relative to the substrate 6. Thus, ions in the plasmas 36 and 38 can be accelerated toward the substrate 6 by the potential difference between the plasmas 36 and 38 and the substrate 6.

Since the present invention is configured thus, it has the following effects.

According to a first aspect of the invention, a plurality of cathodes can be used switchably. Thus, a laminate film including a plurality of heterogeneous films can be formed by evaporation sources which are smaller in number than those in the related art. In addition, by using the cathodes switchably, one vacuum arc evaporation source can be used continuously, substantially without any pause. Thus, the operation rate of the one vacuum arc evaporation source is improved on a large scale.

Thus, according to the invention, a laminate film including a plurality of heterogeneous films can be formed at low cost and with improved productivity. In addition, a film formation apparatus for forming a laminate film including a plurality of heterogeneous films on the surface of a substrate can be made smaller in size and lower in cost, and improved in productivity.

According to a second aspect of the invention, the plasmas generated by the respective cathodes have substantially the same position relative to each other. Thus, there is a further effect that films can be formed on the same substrate 6 on substantially the same conditions, more conveniently for forming a laminate film.

According to a third aspect of the invention, an intermediate thin film containing metal of a group 4A, 5A or 6A of the periodic table can be formed on the surface of the substrate made of metal by use of one evaporation source. And then, a hard carbon thin film can be formed on the intermediate film. Thus, there is a further effect that the hard carbon thin film which is high in adhesion can be formed on the surface of the metal substrate at low cost and with improved productivity.

According to a fourth aspect of the invention, the arc power supply and the changeover switch are provided. Therefore, one arc power supply is needed to be installed for one vacuum arc evaporation source having the plurality of the cathodes. Thus, the number of arc power supplies can be reduced. Also from this point of view, the apparatus can be made simpler in configuration, smaller in size and lower in cost.

According to the fifth aspect of the invention , the magnetic filter can be provided. Therefore, in addition to the above-mentioned effect of the invention stated in first, second, and third aspect, there is a further effect as follows:

Since such a magnetic filter is provided, coarse particles are prevented from adhering to the substrate so that a laminate film which is high in adhesion and surface smoothness can be formed on the substrate.

In addition, by use of the vacuum evaporation source described above, a laminate film can be formed by evaporation sources which are smaller in number than those in the related art. In accordance therewith, the number of magnetic filters can be also reduced. It is therefore possible to make the film formation apparatus simpler in structure, smaller in size and lower in cost, correspondingly.

According to the sixth aspect of the invention, the arc power supply, the changeover switch, and the magnetic filter can be provided. Therefore, there are the above-mentioned effects of the invention stated in the fourth and fifth aspects.

## Claims

1. A vacuum arc evaporation source, comprising:
a plurality of cathodes including different kinds of materials from one another and being insulated electrically from one another,
wherein saidplurality of cathodes are evaporated by vacuum arc discharge to thereby generate plasma having cathode materials.

2. The vacuum arc evaporation source according to Claim 1, wherein said plurality of cathodes are disposed coaxially with one another through an insulating material.

3. The vacuum arc evaporation source according to Claim 1, wherein said plurality of cathodes includes a cathode having a material containing carbon and a cathode having a material containing metal of a group 4A, 5A or 6A in the periodic table.

4. The vacuum arc evaporation source according to Claim 2, wherein each of said cathodes has a circular shape.

5. A film formation apparatus for forming a laminate film including a plurality of heterogeneous films on a surface of a substrate, the apparatus comprising:
a vacuum arc evaporation source having a plurality of cathodes including different kinds of materials from one another and being insulated electrically from one another, wherein said plurality of cathodes are evaporated by vacuum arc discharge to thereby generate plasma having cathode materials on a surface of the cathode;
an arc power supply for supplying arc discharge power to said plurality of cathodes of said vacuum arc evaporation source; and
a switch for alternatively changing over the arc discharge power of said arc power supply toward said plurality of cathodes of said vacuum arc evaporation source.

6. A film formation apparatus for forming a laminate film including a plurality of heterogeneous films on a surface of a substrate, the apparatus comprising:
a vacuum arc evaporation source having a plurality of cathodes including different kinds of materials from one another and being insulated electrically from one another, wherein said plurality of cathodes are evaporated by vacuum arc discharge to thereby generate plasma having cathode materials on a surface of the cathode; and
a magnetic filter for generating a magnetic field to curve plasma generated by said vacuum arc evaporation source so as to removes coarse particles from the plasma and introduce the plasma, the coarse particles of which is removed, into vicinity of the substrate.

7. The film formation apparatus according to claim 6, wherein said magnetic filter comprises:
a curved transport duct;
a magnetic coil for generating the magnetic field curved along said transport duct; and
a DC power supply for exciting said magnetic coil.

8. The film formation apparatus according to claim 6, further comprising;
an arc power supply for supplying arc discharge power to the plurality of cathodes of said vacuum arc evaporation source; and
a switch for alternatively changing over the arc discharge power of said arc power supply toward said plurality of cathodes of said vacuum arc evaporation source.

9. The film formation apparatus according to claim 8; wherein said magnetic filter comprises
a curved transport duct;
a magnetic coil for forming the magnetic field curved along said transport duct; and
a DC power supply for exciting said magnetic coil.

10. The film formation apparatus according to claim 5; further comprising:
a magnet disposed adjacent to the other surface of the cathode opposite to the surface on which the plasma is generated, for controlling a motion of an arc point of the vacuum arc discharge.

11. The film formation apparatus according to claim 6; further comprising:
a magnet disposed adjacent to the other surface of the cathode opposite to the surface on which the plasma is generated, for controlling a motion of an arc point of the vacuum arc discharge.
